# EUROPÄISCHE PATENTSCHRIFT

(11) **EP 1 269 553 B1**
(45) Veröffentlichungstag und Bekanntmachung des Hinweises auf die Patenterteilung: **27.12.2006**
(21) Anmeldenummer: 01927592.4
(22) Anmeldetag: 26.03.2001
(51) Int. Cl.: H01L 51/30, H01L 33/00

(54) **HALBLEITERPOLYMERE, VERFAHREN ZU DEREN HERSTELLUNG UND OPTOELEKTRONISCHES BAUELEMENT**
SEMICONDUCTOR POLYMERS, METHOD FOR THE PRODUCTION THEREOF AND AN OPTOELECTRONIC COMPONENT
POLYMERES SEMI-CONDUCTEURS, PROCEDE PERMETTANT DE LES PRODUIRE ET COMPOSANT OPTOELECTRONIQUE

(30) Priorität: 26.03.2000 DE 10014287
(43) Veröffentlichungstag der Anmeldung: 02.01.2003
(73) Patentinhaber: Osram Opto Semiconductors GmbH, 93049 Regensburg (DE)
(72) Erfinder: VOGG, Günther, 82049 Pullach (DE); BRANDT, Martin, 85748 Garching (DE); STUTZMANN, Martin, 85435 Erding (DE)
(74) Vertreter: Epping - Hermann - Fischer
(86) Internationale Anmeldenummer: PCT/DE2001/001140
(87) Internationale Veröffentlichungsnummer: WO 2001/073862

(56) Entgegenhaltungen:
- EP-A- 0 545 388
- VOGG G ET AL: "From CaSi2 to siloxene: epitaxial silicide and sheet polymer films on silicon" JOURNAL OF CRYSTAL GROWTH, NORTH-HOLLAND PUBLISHING CO. AMSTERDAM, NL, Bd. 203, Nr. 4, Juni 1999 (1999-06), Seiten 570-581, XP004177755 ISSN: 0022-0248
- PATENT ABSTRACTS OF JAPAN vol. 1997, no. 07, 31. Juli 1997 (1997-07-31) & JP 09 064417 A (KOKUSAI DENSHIN DENWA CO LTD <KDD>), 7. März 1997 (1997-03-07)
- VENKATASUBRAMANIAN R ET AL: "PHYSICAL BASIS AND CHARACTERISTICS OF LIGHT EMISSION FROM QUANTIZED PLANAR GE STRUCTURES" PROCEEDINGS OF THE INTERNATIONAL ELECTRON DEVICES MEETING. WASHINGTON, DEC. 8 - 11, 1991, NEW YORK, IEEE, US, 8. Dezember 1991 (1991-12-08), Seiten 91-429-432, XP000342172 ISBN: 0-7803-0243-5
- VOGG G ET AL: "Polygermyne-a prototype system for layered germanium polymers" ADVANCED MATERIALS, 1 SEPT. 2000, VCH VERLAGSGESELLSCHAFT, GERMANY, Bd. 12, Nr. 17, Seiten 1278-1281, XP002174147 ISSN: 0935-9648

## Beschreibung

Kristallines Germanium wird in einer Vielzahl von optoelektronischen Bauelementen verwendet, insbesondere als Strahlungsdetektor. Jedoch können aus diesem Material keine optoelektronischen Bauelemente wie z.B Leuchtdioden oder Laser konstruiert werden, die im sichtbaren oder nahen bis mittleren infraroten Spektralbereich emittieren, da die indirekte Bandlücke von kristallinem Germanium strahlende Übergänge zwischen Leitungs- und Valenzband verhindert.

Sollen die besonderen Eigenschaften von Germanium zum Nachweis von optischer Strahlung in integrierten optoelektronischen Schaltkreisen verwendet werden, die auch lichtemittierende Bauelemente enthalten sollen, so müssen andere Halbleitermaterialien wie z.B. III-V-Verbindungshalbleiter zur Herstellung dieser lichtemittierenden Bauelemente verwendet werden. Die dazu benötigten Verfahren zur Verknüpfung unterschiedlicher Halbleiter sind jedoch in der Regel technisch aufwendig.

Bekannt sind lumineszierende kettenförmige Germaniumpolymere der Form (GeR₂)ₙ, wobei R einwertige Liganden wie H, OH, CH₃, NH₂, Cl usw. darstellt. Diese Polymere werden durch Polymerisation hergestellt und können auf verschiedensten Substraten wie Glas oder leitfähigen transparenten Oxiden abgeschieden werden.

Bei der Verwendung solcher Polymere auf Substraten aus kristallinem Germanium gibt es keine besonderen Vorteile gegenüber der Verwendung anderer lumineszierender Halbleitermaterialien, insbesondere können sich an der Grenzfläche zwischen kristallinem Germanium und diesen Germaniumpolymeren elektronisch aktive Defekte bilden, die die Eigenschaften der so hergestellten lichtemittierenden Bauelemente stark beeinträchtigen.

Weiter bekannt sind sog. statistische Netzwerkpölymere, die durch Polymerisation (Wurtz-Kupplung) hergestellt werden (W. J. Szymanski, G. T. Visscher, P. A. Bianconi, Macromolecules 26, 869 (1993), H. Kishida, H. Tachibana, M. Matsumoto, Y. Tokura, Appl. Phys. Lett. 65, 1358 (1994)).

Diese durch Polymerisation gewonnenen Netzwerkpolymere besitzen eine dreidimensional-verkettete, amorphe Struktur und zeigen lediglich eine schwache Photolumineszenz bei einer Wellenlänge von 540 nm.

Für Kalziumdisilizid CaSi₂ ist bereits seit 1863 bekannt, daß durch Einbringen in Salzsäure die Kalziumatome aus dem Kristallgitter des CaSi₂ entfernt werden können und sich ein schichtförmiges Siliziumpolymer bildet (F. Wöhler, Liebigs Annalen 127, 257 (1863)). Dabei handelt es sich um eine sog. topochemische Reaktion, bei der die Struktur und Stapelfolge der in diesem Material vorhandenen Si-Ebenen erhalten bleibt (A. Weiss, G. Beil, H. Meyer, Z. Naturforsch. 35b, 25 (1979)). Diese Reaktion wird bevorzugt bei 0°C durchgeführt (H. Kautsky, Z. anorg. Chem. 117, 209 (1921)).

In den Druckschriften EP 0545 388, Vogg et al. Journal of Crystal Growth, North Holland Publishing Co. Amsterdam (1999), Seiten 570 bis 581 und JP 09 064417 ist die Herstellung von Siloxen oder Siloxenderivaten durch Reaktion von epitaktisch auf einem Siliziumsubstrat aufgebrachten Kalziumdisilizid mittels HCl beschrieben.

Die Druckschrift R. Venkatasubramanian et al. Proc. of the International Electron Device Meeting, Washington Dec. 8-11, 1991, IEEE, Seiten 91-429-432 beschreibt die Charakterisierung von Fotolumineszenz quantisierter planarer Germaniumstrukturen.

Die Druckschriften JP 08231949 und JP 08231947 betreffen weiterhin ein organisches lumineszierendes Bauteil auf Basis von Netzwerkpolymeren, wie Polysilanen, Polygermaniden und Silan-Germaniumhydrid-Copolymeren, während die Druckschrift US 5280183 mikroelektronische Bauteile mit Multiring-Phthalocyanin-Verbindungen betrifft.

Es ist Aufgabe der Erfindung, Halbleiterpolymere mit verbesserten Lumineszenzeigenschaften sowie ein Herstellungsverfahren hierfür anzugeben. Weiterhin ist es Aufgabe der Erfindung, mit diesen ein optoelektronisches Bauelement zu schaffen.

Diese Aufgabe wird durch die Merkmal der Patentansprüche 1, 13, 18 bzw. 34 gelöst. Vorteilhafte Weiterbildungen der Erfindung sind Gegenstand der abhängigen Ansprüche.

Nachfolgend wird die Erfindung in Verbindung mit den Figuren 1 bis 5 näher erläutert.

Es zeigen
Figur 1 eine schematische Darstellung des strukturellen Aufbaus einer ersten Ausführungsform eines Germanium-Schichtpolymers,
Figur 2 eine schematische Darstellung des strukturellen Aufbaus einer zweiten Ausführungsform eines Germanium-Schichtpolymers im Vergleich mit dem strukturellen Aufbau der ersten Ausführungsform und eines Materials zur Herstellung dieser Schichtpolymere,
Figur 3 ein Röntgendiffraktogramm der beiden Ausführungsformen nach Figur 1 bzw. 2 sowie des Materials zur Herstellung der Schichtpolymere,
Figur 4 ein Photolumineszenzspektrum der beiden Ausführungsformen und
Figur 5 eine schematische Schnittdarstellung eines erfindungsgemäßen optoelektronischen Bauelements.

Erfindungsgemäß werden werden Germaniumpolymere bzw. Silizium-Germanium-Polymere mittels topochemischer Umwandlung von geeigneten Germaniden bzw. gemischten Silizidgermaniden, z.B. durch Umwandlung von Ca(Si₁₋ₓGeₓ)₂, 0<x≤1 gebildet.

Vorzugsweise wird hierzu ein kristallines Substrat mit geeigneter Kristallstruktur oder ein Substrat mit einer Bufferschicht, die eine geeignete Kristallstruktur aufweist, verwendet. Dabei kan die Bufferschicht auch mehrlagig ausgeführt sein. Besonders eignen sich Germanium- bzw. Germanium-Siliziumsubstrate. Die Schichtpolymere bilden dabei einen epitaktischen Film auf dem Substrat, elektronisch aktive Defekte an der Grenzfläche werden in nur sehr geringerem Maße gebildet.

Zur Herstellung der schichtförmigen Germaniumpolymere wird zunächst durch Reaktion von Ca mit Germanium das Germanid CaGe₂ gebildet. Dies kann durch Deposition von Ca mittels eines geeigneten Aufbringverfahrens auf ein Germaniumsubstrat mit nachfolgender Temperung zur Bildung von CaGe₂, durch Deposition von Ca auf ein geheiztes Germaniumsubstrat, bei dem sich ohne nachfolgende Temperung CaGe₂ bildet (Reactive Deposition Epitaxy), oder durch Codeposition von Ca und Ge auf ein Substrat (z.B durch Aufdampfen, Sputtern oder Molekularstrahlepitaxie), vorzugsweise ein Germaniumsubstrat, mit nachfolgender Temperung oder durch Codeposition auf ein geheiztes Germaniumsubstrat geschehen.

Bevorzugt wird epitaktisches CaGe₂ auf kristallinem Germanium durch Reactive Deposition Epitaxy bei einer Temperatur des Germaniumsubstrates von 700 bis 900°C und bei einem Kalziumfluß von ungefähr 10 nm pro Minute hergestellt. Besonders bevorzugt ist eine Temperatur von 810°C. Dabei wird eine Wachstumsrate von etwa 1 µm pro Stunde erreicht.

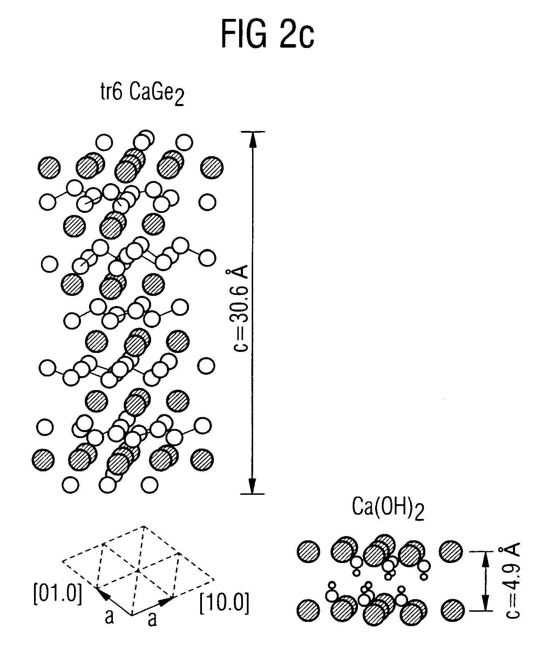

Kalziumdigermanid kann in zwei Kristallstrukturen kristallisieren: tr6 CaGe₂ (Raumgruppe *D*_{3d}⁵) mit den Gitterkonstanten a=4.0 Å und c=30.6 Å und h2 CaGe₂ (Raumgruppe *C*₆ᵥ⁴) mit den Gitterkonstanten a=4.0 Å und c=10.2 Å. Die Kristallstruktur von tr6 CaGe₂ ist in Figur 2c dargestellt. Es handelt sich dabei um eine geschichtete Struktur, die aus einer Abfolge von gewellten Germanium(doppel)ebenen und Ebenen aus Kalziumatomen bestehen (H. J. Wallbaum, Naturwissenschaften 32, 76 (1944)). In tr6 CaGe₂ gibt es eine 6-fache Stapelfolge, in h2 CaGe₂ hingegen eine nur 2-fache Stapelfolge.

Die Umwandlung von CaGe₂ in schichtförmige Germaniumpolymere geschieht durch eine topochemische Reaktion. Um lumineszierende schichtförmige Germaniumpolymere zu erhalten, bei denen die Ebenenstruktur der Germaniumatome erhalten bleibt, wird bei der Erfindung die Umwandlung in einer Lösung, die HCl enthält, vorzugsweise bei Temperaturen unter -5°C, besonders bevorzugt in konzentrierter HCl (37% in Wasser) bei -30°C durchgeführt. Unter diesen Bedingungen bilden sich schichtförmige Germaniumpolymere der Form (GeH)ₙ mit dem chemischen Namen Polygermin, die weitgehend frei von Sauerstoff- und Chlor-Verunreinigungen sind.

Eine erste Form von Germaniumschichtpolymeren, die durch Umsetzung in HCl gewonnenen werden, wird mit Polygermin A bezeichnet.

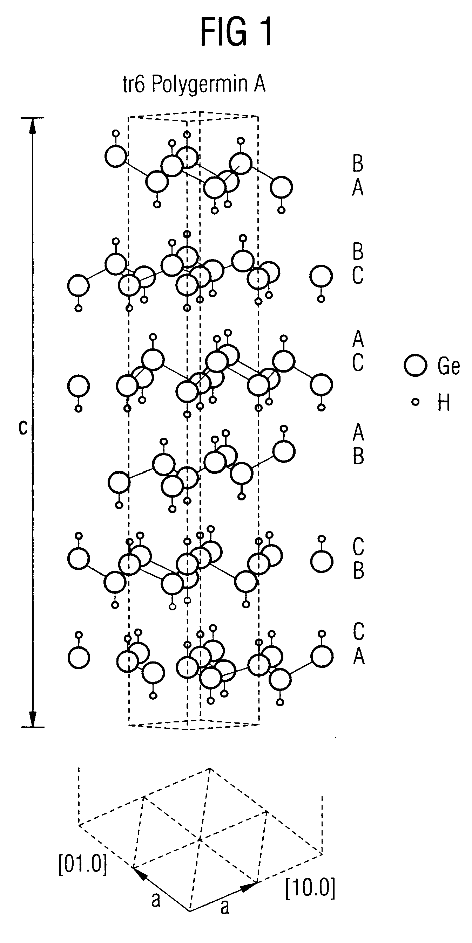

Die Struktur von Polygermin A ist schmatisch in Figur 1 dargestellt. Bei der Umwandlung von tr6 CaGe₂ mit HCl entsteht ein tr6 (GeH)ₙ mit derselben Raumgruppe *D*_{3d}⁵ wie tr6 CaGe₂ und den Gitterkonstanten a=4.0 Å und c=33.9 Å, entsprechend bei der Umwandlung von h2 CaGe₂ ein h2 (GeH)ₙ.

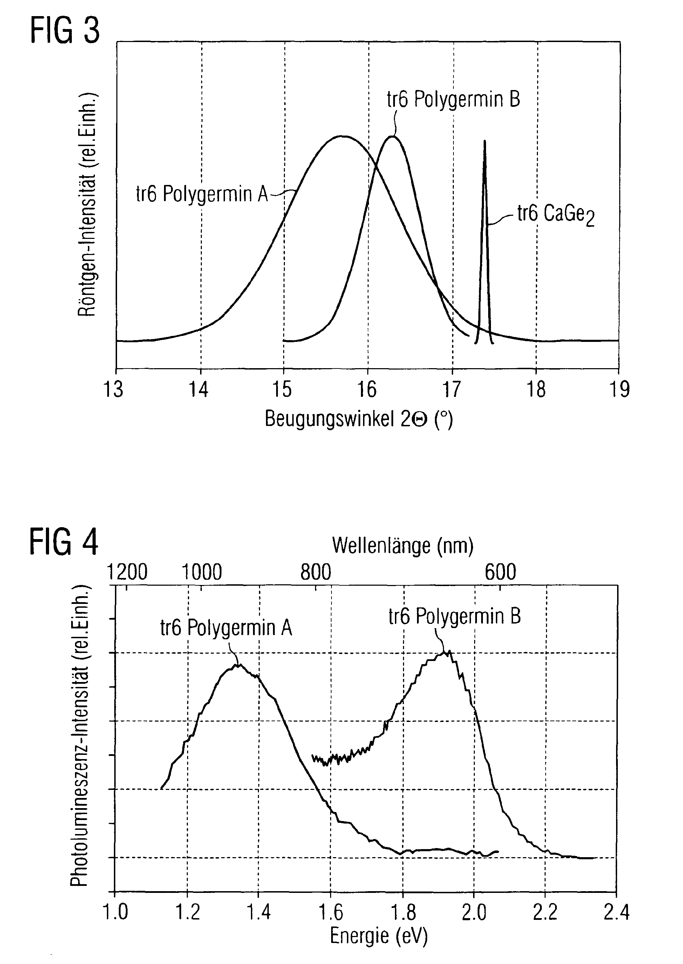

Durch die nur noch schwache Bindung zwischen benachbarten (GeH)ₙ-Ebenen kommt es zur Ausbildung von turbostratischer Unordnung zwischen den Ebenen und einer Variation des Ebenenabstandes c/6 zwischen 5.4 und 5.9 Å, wie aus der Breite des in Bragg-Brentano-Geometrie mit CuK_{α}-Strahlung aufgenommenen Röntgendiffraktogramms, dargestellt in Figur 3, des (006)-Reflexes von tr6 (GeH)ₙ entnommen werden kann. Wie der ursprüngliche CaGe₂-Film ist der durch die topochemische Umwandlung erhaltene (GeH)ₙ-Film epitaktisch zu dem Germaniumsubstrat orientiert.

In Figur 4 ist ein Photolumineszenzspektrum von Polygermin A dargestellt. Das Schichtpolymer zeigt eine starke infrarote Photolumineszenz bei etwa 900 nm (1,4eV). Diese Lumineszenz ist deutlich stärker als bei den eingangs genannten Germaniumnetzpolymeren ausgeprägt.

Eine Lumineszenz im nahen infraroten Wellenlängenbereich hat für Anwendungen dieser Schichtpolymere in integrierten optoelektronischen Bauelementen zusammen mit Photodioden aus Germanium besondere Vorteile, weil sie wesentlich näher an der höchsten spektralen Empfindlichkeit von kristallinem Germanium ist.

Bei einem zweiten erfindungsgemäßen Verfahren werden Germaniumschichtpolymere ohne Verwendung von Salzsäure durch topochemische Umwandlung von CaGe₂ mittels Wasser hergestellt. Bevorzugt wird dabei CaGe₂ feuchter Luft ausgesetzt, besonders bevorzugt bei einer relativen Luftfeuchte zwischen 10 bis 100% und bei einer Temperatur zwischen 10 und 30°C. Alternativ können Germaniumschichtpolymere durch Einbringen von CaGe₂ bzw. mit CaGe₂ beschichtete Substrate in Wasser hergestellt werden.

Bei dieser Umwandlung kommt es nicht zu einer Entfernung der Kalziumatome aus dem Kristallgitter, vielmehr wird zusätzlich Wasser in den Kristall eingebaut. Je nach der Kristallstruktur des verwendeten CaGe₂-Ausgangsmaterials werden wiederum kristalline Schichtpolymere mit tr6 bzw. h2 Kristallstruktur erzeugt. Diese Schichtpolymere besitzen einen Schichtaufbau mit alternierenden Ge- und Ca-haltigen Schichten.

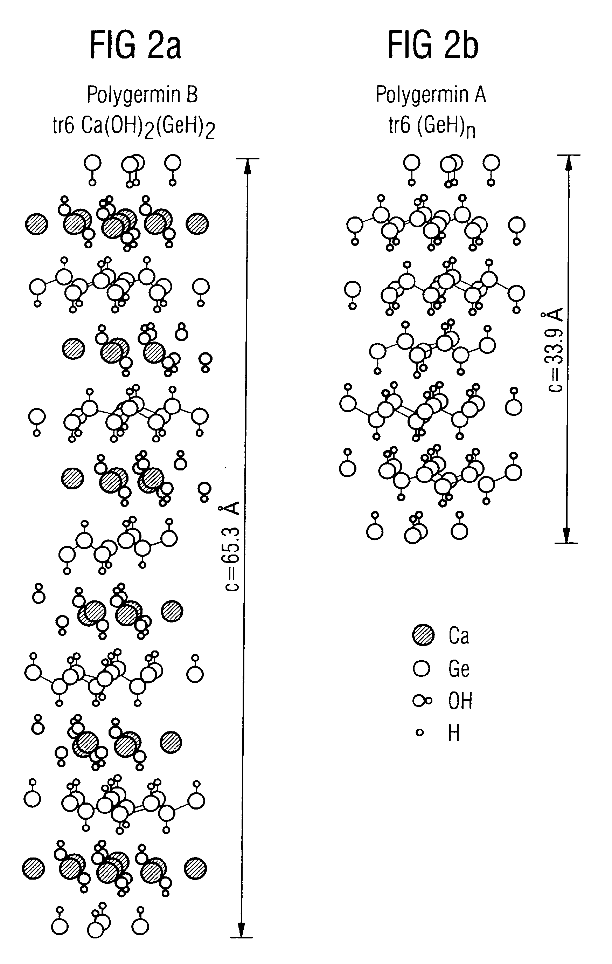

An feuchter Luft oder durch Einbringen von CaGe₂ in Wasser erzeugte Germaniumschichtpolymere sind im folgenden mit Polygermin B bezeichnet. Ihr struktureller Aufbau ist für die tr6 Kristallstruktur in Figur 2a dargestellt. Zum Vergleich zeigt Figur 2b nochmals die Struktur von Polygermin A und Figur 2c die Struktur von CaGe₂.

Polygermin B weist wie Polygermin A (GeH)ₙ-Schichtebenen auf. Im Gegensatz zu Polygermin A sind diese Schichtebenen durch ((CaOH)₂)ₙ-Ebenen voneinander getrennt. Die Gitterkonstanten betragen a=4.0 Å und c=65.3 Å, wobei der Abstand zwischen benachbarten Germaniumebenen aus den oben genannten Gründen zwischen c/6=10.6 Å und 11.0 Å variiert (vgl. Figur 3). An feuchter Luft umgewandeltes Polygermin B zeigt eine starke Photolumineszenz bei 650 nm (vgl. Figur 4).

Durch chemische Substitution des Wasserstoffs durch andere geeignete Liganden an den Germaniumebenen in Polygermin läßt sich der Abstand der Germaniumebenen sowie die Größe der Bandlücke und damit die Wellenlänge der Lumineszenz verändern. Dabei können die H-Atome ganz oder teilweise durch andere einwertige Liganden wie Halogenatome, OH- bzw. NH₂-Gruppen oder Alkylgruppen -CH₃, -C₂H₅ usw. substituiert werden. Zur Substitution mit OH-Gruppen wird dazu bevorzugt zunächst eine Substitution mit Br durch Einbringen des Polygermins in HBr durchgeführt, gefolgt von der Substitution der Br-Liganden durch OH-Gruppen in Wasser. Die Substitution mit Alkanen erfolgt bevorzugt durch Hydrosilylierung von Alkenen. Dabei kann der Ebenenabstand von 5 bis 60 Å, die Lumineszenzwellenlänge von 400 bis 1600 nm variieren. Die für die Realisierung optoelektronischer Bauelemente wichtige Dotierung der schichtförmigen Germaniumpolymere zur Erhöhung der Leitfähigkeit kann durch Interkalation von Alkali- oder Erdalkaliatomen, bevorzugt mit Li, K, oder Ca erfolgen.

Bei einer bevorzugten Weiterbildung der Erfindung weisen die Schichtpolymere gemischte Germanium-Silizium-Schichtebenen auf. Damit entstehen weitere vorteilhafte Schichtpolymere und Schichtstrukturen.

Silizium-Germanium-Schichtpolymere, in denen die einzelnen Ebenen gemischt aus Silizium- und Germaniumatomen zusammengesetzt sind, lassen sich erfindungsgemäß durch Herstellung von Ca(Si₁₋ₓGeₓ)₂ aus auf geeigneten kristallinen Substraten abgeschiedenen Si₁₋ₓGeₓ Legierungen, entsprechend der Herstellung von CaGe₂, und nachfolgende topochemische Umwandlung unter Verwendung von HCl- oder H₂O-haltigen Lösungen oder feuchter Luft herstellen.

Schichtstrukturen, die aus einer Abfolge einzelner Lagen von reinen Germaniumschichtpolymeren und Siliziumschichtpolymeren bestehen, lassen sich erfindungsgemäß durch die Herstellung von CaGe₂/CaSi₂-Übergittern z.B. durch Aufdampfen, Sputtern oder Molekularstrahlepitaxie und nachfolgender topochemischer Umwandlung unter Verwendung von HCl- oder H₂O-haltigen Lösungen gewinnen. Die obengenannten Ausgestaltungen der Erfindung für Germaniumschichtpolymere beziehen sich auch auf Silizium-Germanium-Schichtpolymere. Weitergehend können die Ebenenstrukturen auch andere Halbleiteratome enthalten oder aus diesen gebildet sein. Unter Halbleiteratomen sind Atome von Materialien mit halbleitenden Eigenschaften wie beispielsweise GaAs, AlGaAs, GaAlP, GaN, InGaAlN zu verstehen.

Die besonderen Vorteile von Silizium-GermaniumSchichtpolymeren in optoelektronischen Bauelementen sind u.a. die Möglichkeit der Einstellung der Bandlücke bzw. der Lumineszenz nur durch die Variation der relativen Anteile der Silizium- bzw. Germaniumatome ohne chemische Substitution von Liganden bzw. die Möglichkeit der Erzeugung "mehrfarbiger" Lumineszenz in einem optoelektronischen Bauelement, da Silzium- und Germaniumschichtpolymere Lumineszenz bei unterschiedlichen Wellenlängen aufweisen.

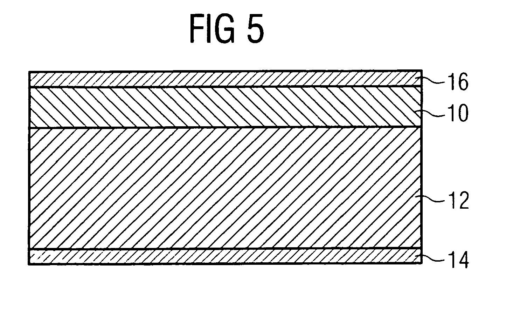

In Figur 5 ist ein ein erfindungsgemäßes Schichtpolymer enthaltendes optoelektronisches Bauelement dargestellt. Dabei ist ein Germaniumschichtpolymer 10 auf einem Substrat 12 aus kristallinem Germanium angeordnet. Vorzugsweise wird das Germaniumschichtpolymer 10 auf dem Germaniumsubstrat 12 hergestellt. Das Germaniumsubstrat wirkt dabei als ein elektrischer Kontakt an der Polymerschicht und kann zur Verminderung des Serienwiderstandes in an sich bekannter Weise dotiert sein.

Der elektrische Kontakt zum Substrat kann dabei z.B. durch einen geeigneten metallischen Rückseitenkontakt 14 realisiert werden.

Als Vorderseitenkontakt werden metallische Filme oder Filme aus elektrisch leitenden Oxiden 16 auf die Polymerschicht 10 aufgebracht. Damit Licht durch die Oberfläche des Bauelementes treten kann, ist der Vorderseitenkontakt vorzugsweise strahlungsdurchlässig ausgeführt. Hierzu kann ein metallischer Vorderseitenkontakt beispielsweise hinreichend dünn und damit optisch zumindest teiltransparent gebildet sein. Alternativ kann der Vorderseitenkontakt als Fenster gebildete Ausnehmungen aufweisen.

Zur Verbesserung der Diodeneigenschaften des Bauelementes kann die Schicht 10 dotiert sein. Gegebenfalls ist die Schicht 10 räumlich selektiv nur in der Nähe des Überganges zum Substrat 12 oder in der Nähe des Überganges zum Vorderseitenkontakt 16 dotiert. Bevorzugt werden Metalle mit niedriger Austrittsarbeit wie z.B. Sr, Ca, Mg oder Al als Vorderseitenkontakt, p-Typ dotiertes Germanium mit einer spezifischen Leitfähigkeit zwischen 0.01 und 1000 1/Ωcm als Substratmaterial und A1 als Rückseitenkontakt verwendet. Weitergehend können auch elektrisch leitfähige Oxide, beispielsweise ZnO, SnO oder ITO (Indium Tin Oxide) als Kontaktmaterial verwendet werden. Selbstverständlich kann das Schichtpolymer 10 auch ein Silizium-Germanium-Polymer sein.

Die räumliche Orientierung der Germaniumebenen bezüglich der Oberfläche des Germaniumsubstrates hängt in den geschichteten Polymeren von der Kristallorientierung des Substrates ab. Für Germaniumsubstrate mit einer (111)-Oberfläche liegen die Ebenen der schichtförmigen Polymere parallel zur Substratoberfläche.

Die elektrische Leitfähigkeit der Schichtpolymere ist wegen ihrer Struktur stark anisotrop, die Leitfähigkeit parallel zu den Ebenen ist dabei wesentlich größer als die Leitfähigkeit senkrecht dazu. Hat das Germaniumsubstrat (12) deshalb eine (111)-Oberfläche, so hat die Polymerschicht (10) in dem in Figur 5 dargestellten Bauelement einen wesentlich höheren Widerstand als eine gleich dicke Polymerschicht, die auf einem anders orientierten Substrat hergestellt wurde. Zur Reduktion des Widerstandes in der Polymerschicht und zur Erhöhung der Lumineszenzausbeute werden deshalb Germaniumsubstrate mit einer von (111) verschiedenen Orientierung bevorzugt. Besonders bevorzugt zur Herstellung von Leuchtdioden und Lasern werden Substrate mit einer (110)-Oberfläche.

Ein optoelektronisches Bauelement mit einem Germanium- oder Silizium-Germanium-Schichtpolymer kann als Leuchtdiode oder Laser ausgebildet sein, indem Ladungsträger in die Polymerschicht elektrisch injiziert werden. Es kann jedoch auch zum Nachweis optischer Strahlung, beispielsweise als Photodiode oder als Photoleiter, verwendet werden.

Unter Verwendung von schichtförmigen Germanium- und Silizium-Germanium-Polymeren lassen sich darüberhinaus integrierte optoelektronische Schaltkreise realisieren, in denen die verwendeten Halbleitermaterialien vorzugsweise ausschließlich auf Germanium basieren und insbesondere aus dem kristallinem Germaniumsubstrat des Schaltkreises selbst hergestellt worden sind. Dabei können mit erfindungsgemäßen Schichtpolymeren lichtemittierende Bauelemente zur Konstruktion von Leuchtdioden oder Lasern realisiert sowie, Photodetektoren zum Nachweis von optischer Strahlung, z.B. durch pn-Photodioden aus kristallinem Germanium, durch selektive Dotierung gebildet werden. Weiterhin können lichtemittierende und lichtdetektierende Bauelemente durch optische Wellenleiter, z.B. aus GeO₂, das durch selektive Oxidation des kristallinen Germaniums gebildet wird, verbunden sein.

Die Erläuterung der Erfindung anhand der Ausführungsbeispiele stellt selbstverständlich keine Einschränkung der Erfindung hierauf dar. Wird hier auf Germaniumschichtpolymere, auf optoelektronische Bauelemente auf deren Basis und auf deren Verwendung Bezug genommen, so sind davon auch Silizium-Germanium-Schichtpolymere umfaßt.

## Patentansprüche

1. Germaniumschichtpolymer,
erhältlich durch topochemische Umwandlung von Ca(Si₁₋ₓGeₓ)₂, mit 0<x≤1.

2. Schichtpolymer nach Anspruch 1,
erhältlich durch topochemische Umwandlung von CaGe₂.

3. Schichtpolymer nach einem der Ansprüche 1 oder 2,
wobei die topochemische Umwandlung in einer Lösung, die HCl enthält, durchgeführt wird.

4. Schichtpolymer nach der vorhergehenden Ansprüche,
wobei die topochemische Umwandlung bei -30°C mit konzentrierter HCl durchgeführt wird.

5. Schichtpolymer nach einem der Ansprüche 1 oder 2,
wobei die topochemische Umwandlung mit einer H₂O enthaltenden Flüssigkeit durchgeführt wird.

6. Schichtpolymer nach einem der Ansprüche 1 oder 2,
wobei die topochemische Umwandlung in Luft mit einer relativen Luftfeuchtigkeit von 10% bis 100% durchgeführt wird.

7. Schichtpolymer nach einem der vorhergehenden Ansprüche, erhältlich **dadurch**, dass eine epitaktische Ca(Si₁₋ₓGeₓ)₂-Schicht, 0<x≤1 auf einem Substrat aus kristallinem Germanium oder Siliziumgermanium abgeschieden wird.

8. Schichtpolymer nach dem vorhergehenden Ansprüche,
wobei die epitaktische Ca(Si₁₋ₓGeₓ)₂-Schicht, 0<x≤1 durch Deposition von Ca auf ein Si₁₋ₓGeₓ-Substrat, 0<x≤1 mit nachfolgender Temperung, durch Deposition von Ca auf ein geheiztes Si₁₋ₓGeₓ-Substrat, 0<x≤1, durch Codeposition von Ca, Ge und Si auf ein Substrat, vorzugsweise ein Germanium- oder ein Si₁₋ₓGeₓ-Substrat, 0<x≤1, mit nachfolgender Temperung oder durch Codeposition von Ca, Ge und Si auf ein geheiztes Substrat, vorzugsweise ein Germanium- oder Si₁₋ₓGeₓ-Substrat, 0<x≤1, hergestellt wird.

9. Schichtpolymer nach einem der vorhergehenden Ansprüche,
wobei H-Liganden der Schichtpolymere zunächst durch Einbringen des Schichtpolymers in HBr mit Br substituiert und dann die Br-Liganden durch OH-Gruppen in Wasser substituiert werden.

10. Schichtpolymer nach einem der Ansprüche 1 bis 8,
wobei H-Liganden der Schichtpolymere mit Alkylgruppen durch Hydrosilylierung von Alkenylgruppen substituiert werden.

11. Schichtpolymer nach einem der vorhergehenden Ansprüche,
wobei die Schichtpolymere durch Interkalation mit Alkali- oder Erdalkaliatomen dotiert werden.

12. Schichtpolymer nach Anspruch 11,
wobei die Schichtpolymere durch Interkalation mit Li-, K- oder Ca-Atomen dotiert werden.

13. Schichtpolymer nach einem der vorhergehenden Ansprüche, aufweisend ein Material aus einer Gruppe, die gebildet wird durch GaAs, AlGaAs, GaAlP, GaN und InGaAlN.

14. Verfahren zur Herstellung eines Schichtpolymers,
**dadurch gekennzeichnet , daß**
das Schichtpolymer mittels topochemischer Umwandlung von Ca(Si₁₋ₓGeₓ)₂, 0<x≤1 hergestellt wird.

15. Verfahren nach Anspruch 14,
**dadurch gekennzeichnet, daß** eine epitaktische Ca(Si₁₋ₓGeₓ)₂-Schicht, 0<x≤1 auf einem Substrat aus kristallinem Germanium oder Siliziumgermanium zur Herstellung des Schichtpolymers verwendet wird.

16. Verfahren nach Anspruch 14 oder 15,
**dadurch gekennzeichnet , daß**
die epitaktische Ca(Si₁₋ₓGeₓ)₂-Schicht, 0<x≤1 durch Deposition von Ca auf ein Si₁₋ₓGeₓ-Substrat, 0<x≤1 mit nachfolgender Temperung, durch Deposition von Ca auf ein geheiztes Si₁₋ₓGeₓ-Substrat, 0<x≤1, durch Codeposition von Ca, Ge und Si auf ein Substrat, vorzugsweise ein Germanium- oder ein Si₁₋ₓGeₓ-Substrat, 0<x≤1, mit nachfolgender Temperung oder durch Codeposition von Ca, Ge und Si auf ein geheiztes Substrat, vorzugsweise ein Germanium- oder
Si₁₋ₓGeₓ-Substrat, 0<x≤1, hergestellt wird.

17. Verfahren nach einem der Ansprüche 14 bis 16,
**dadurch gekennzeichnet , daß**
die topochemische Umwandlung mit einer HCl oder H₂O enthaltenden Flüssigkeit durchgeführt wird.

18. Verfahren nach einem der Ansprüche 14 bis 17,
**dadurch gekennzeichnet , daß**
die topochemische Umwandlung in Luft mit einer relativen Luftfeuchtigkeit von 10 bis 100% durchgeführt wird.

19. Optoelektronisches Bauelement,
**dadurch gekennzeichnet , daß**
es ein Schichtpolymer nach einem der Ansprüche 1 bis 13 umfasst.

20. Optoelektronisches Bauelement nach Anspruch 19,
**dadurch gekennzeichnet , daß**
das Schichtpolymer (10) luminesziert.

21. Optoelektronisches Bauelement nach einem der Ansprüche 19 bis 20,
**dadurch gekennzeichnet , daß**
die Lumineszenz ein Intensitätsmaximum bei einer Wellenlänge zwischen 400 nm und 1600 nm aufweist.

22. Optoelektronisches Bauelement nach einem der Ansprüche 19 bis 21,
**dadurch gekennzeichnet , daß**
es ein kristallines Substrat umfasst, auf dem das Schichtpolymer hergestellt ist.

23. Optoelektronisches Bauelement nach Anspruch 22,
**dadurch gekennzeichnet , daß**
das kristalline Substrat (12) ein Germaniumsubstrat oder ein Siliziumgermaniumsubstrat ist.

24. Optoelektronisches Bauelement nach einem der Ansprüche 22 bis 23,
**dadurch gekennzeichnet , daß**
das Substrat (12) eine derartige Orientierung aufweist, daß die Struktur des Schichtpolymers (10) nicht parallel zur Oberfläche des Substrats orientiert ist.

25. Optoelektronisches Bauelement nach einem der Ansprüche 22 bis 24,
**dadurch gekennzeichnet , daß**
das Substrat (12) eine (110)-Oberfläche aufweist.

26. Optoelektronisches Bauelement nach einem der Ansprüche 22 bis 25,
**dadurch gekennzeichnet , daß**
ein dotiertes Substrat (12) verwendet ist.

27. Optoelektronisches Bauelement nach einem der Ansprüche 22 bis 26,
**dadurch gekennzeichnet , daß**
auf dem Schichtpolymer (10) ein elektrischer Kontakt (16) angeordnet ist.

28. Optoelektronisches Bauelement nach Anspruch 27,
**dadurch gekennzeichnet , daß**
der elektrische Kontakt (16) aus einem Metall oder einem elektrisch leitfähigen Oxid besteht.

29. Optoelektronisches Bauelement nach einem der Ansprüche 27 bis 28,
**dadurch gekennzeichnet , daß**
der Kontakt (16) lichtdurchlässig ist.

30. Optoelektronisches Bauelement nach einem der Ansprüche 27 bis 29,
**dadurch gekennzeichnet, daß**
der Kontakt (16) Sr, Ca, Mg, Al, Zn, In, ZnO, InO oder InZnO enthält.

31. Optoelektronisches Bauelement nach einem der Ansprüche 19 bis 30,
**dadurch gekennzeichnet, daß**
das Schichtpolymer (10) ganz oder räumlich selektiv dotiert ist.

32. Optoelektronisches Bauelement nach einem der Ansprüche 19 bis 31,
**dadurch gekennzeichnet , daß**
es eine Leuchtdiode oder Laserdiode ist.

33. Optoelektronisches Bauelement nach einem der Ansprüche 19 bis 31,
**dadurch gekennzeichnet, daß**
es zum Nachweis optischer Strahlung dient.

34. Integrierter Schaltkreis,
**dadurch gekennzeichnet , daß**
er ein Schichtpolymer nach einem der Ansprüche 1 bis 13 oder ein optoelektronisches Bauelement nach einem der Ansprüche 19 bis 33 umfasst.

## Claims

1. Layered germanium polymer, obtainable by topochemical reaction of Ca(Si₁₋ₓGeₓ)₂, with 0<x≤1.

2. Layered polymer according to Claim 1, obtainable by topochemical reaction of CaGe₂.

3. Layered polymer according to one of Claims 1 and 2, wherein the topochemical reaction is carried out in a solution which contains HCl.

4. Layered polymer according to one of the preceding claims, wherein the topochemical reaction is carried out at -30°C with concentrated HCl.

5. Layered polymer according to one of Claims 1 and 2, wherein the topochemical reaction is carried out with a liquid containing H₂O.

6. Layered polymer according to one of Claims 1 and 2, wherein the topochemical reaction is carried out in air with a relative humidity of from 10% to 100%.

7. Layered polymer according to one of the preceding claims, obtainable by depositing an epitaxial Ca(Si₁₋ₓGeₓ)₂ layer, 0<x≤1 on a crystalline germanium or silicon-germanium substrate.

8. Layered polymer according to one of the preceding claims, wherein the epitaxial Ca(Si₁₋ₓGeₓ)₂ layer, 0<x≤1 is produced by depositing Ca on an Si₁₋ₓGeₓ substrate, 0<x≤1 with subsequent heat treatment, by depositing Ca on a heated Si₁₋ₓGeₓ substrate, 0<x≤1, by codepositing Ca, Ge and Si on a substrate, preferably a germanium or Si₁₋ₓGeₓ substrate, 0<x≤1 with subsequent heat treatment or by codepositing Ca, Ge and Si on a heated substrate, preferably a germanium or Si₁₋ₓGeₓ substrate, 0<x≤1.

9. Layered polymer according to one of the preceding claims, wherein H ligands of the layered polymers are firstly substituted with Br by introducing the layered polymer into HBr and then the Br ligands are substituted by OH groups in water.

10. Layered polymer according to one of Claims 1 to 8, wherein H ligands of the layered polymers are substituted with alkyl groups by hydrosilylation of alkenyl groups.

11. Layered polymer according to one of the preceding claims, wherein the layered polymers are doped by intercalation with alkali or alkaline earth metal atoms.

12. Layered polymer according to Claim 11, wherein the layered polymers are doped by intercalation with Li, K or Ca atoms.

13. Layered polymer according to one of the preceding claims, comprising a material from a group which is formed by GaAs, AlGaAs, GaAlP, GaN and InGaAlN.

14. Method for the production of a layered polymer, **characterized in that** the layered polymer is produced by means of topochemical reaction of Ca (Si₁₋ₓGeₓ)₂, with 0<x≤1.

15. Method according to Claim 14, **characterized in that** an epitaxial Ca(Si₁₋ₓGeₓ)₂ layer, 0<x≤1 on a crystalline germanium or silicon-germanium substrate is used for producing the layered polymer.

16. Method according to one of Claims 14 or 15, **characterized in that** the epitaxial Ca(Si₁₋ₓGeₓ)₂ 2 layer, 0<x<-1 is produced by depositing Ca on an Si₁₋ₓGeₓ substrate, 0<x<-1 with subsequent heat treatment, by depositing Ca on a heated Si₁₋ₓGeₓ substrate, 0<x≤1, by codepositing Ca, Ge and Si on a substrate, preferably a germanium or Si₁₋ₓGeₓ substrate, 0<x≤1 with subsequent heat treatment or by codepositing Ca, Ge and Si on a heated substrate, preferably a germanium or Si₁₋ₓGeₓ substrate, 0<x≤1.

17. Method according to one of Claims 14 to 16, **characterized in that** the topochemical reaction is carried out with a liquid containing HCl or H₂O.

18. Method according to one of Claims 14 to 17, **characterized in that** the topochemical reaction is carried out in air with a relative humidity of from 10% to 100%.

19. Optoelectronic component, **characterized in that** it comprises a layered polymer according to one of Claims 1 to 13.

20. Optoelectronic component according to Claim 19, **characterized in that** the layered polymer (10) luminesces.

21. Optoelectronic component according to one of Claims 19 to 20, **characterized in that** the luminescence has an intensity maximum at a wavelength of between 400 nm and 1600 nm.

22. Optoelectronic component according to one of Claims 19 to 21, **characterized in that** it comprises a crystalline substrate on which the layered polymer is produced.

23. Optoelectronic component according to Claim 22, **characterized in that** the crystalline substrate (12) is a germanium substrate or a silicon-germanium substrate.

24. Optoelectronic component according to one of Claims 22 to 23, **characterized in that** the substrate (12) has an orientation such that the structure of the layered polymer (10) is not oriented parallel to the surface of the substrate.

25. Optoelectronic component according to one of Claims 22 to 24, **characterized in that** the substrate (12) has a (110)-surface.

26. Optoelectronic component according to one of Claims 22 to 25, **characterized in that** a doped substrate (12) is used.

27. Optoelectronic component according to one of Claims 22 to 26, **characterized in that** an electrical contact (16) is arranged on the layered polymer (10).

28. Optoelectronic component according to Claim 27, **characterized in that** the electrical contact (16) consists of a metal or an electrically conductive oxide.

29. Optoelectronic component according to one of Claims 27 to 28, **characterized in that** the contact (16) is translucent.

30. Optoelectronic component according to one of Claims 27 to 29, **characterized in that** the contact (16) contains Sr, Ca, Mg, Al, Zn, In, ZnO, InO or InZnO.

31. Optoelectronic component according to one of Claims 19 to 30, **characterized in that** the layered polymer (10) is fully or locally selectively doped.

32. Optoelectronic component according to one of Claims 19 to 31, **characterized in that** it is a light-emitting diode or laser diode.

33. Optoelectronic component according to one of Claims 19 to 31, **characterized in that** it is used to detect optical radiation.

34. Integrated circuit, **characterized in that** it comprises a layered polymer according to one of Claims 1 to 13 or an optoelectronic component according to one of Claims 19 to 33.

## Revendications

1. Polymère en couche en germanium que l'on peut obtenir par transformation topochimique de Ca(Si₁₋ₓGeₓ)₂, avec 0 < x ≤ 1.

2. Polymère en couche suivant la revendication 1, pouvant être obtenu par transformation topochimique de CaGe₂.

3. Polymère en couche suivant l'une des revendications 1 ou 2, dans lequel la transformation topochimique est effectuée dans une solution qui contient du HCl.

4. Polymère en couche suivant l'une des revendications précédentes, dans lequel la transformation topochimique est effectuée à -30°C avec du HCl concentré.

5. Polymère en couche suivant l'une des revendications 1 ou 2, dans lequel la transformation topochimique est effectuée avec un liquide contenant du H₂O.

6. Polymère en couche suivant l'une des revendications 1 ou 2, dans lequel la transformation topochimique est effectuée dans l'air ayant un taux d'humidité relatif compris entre 10 % et 100 %.

7. Polymère en couche suivant l'une des revendications précédentes, pouvant être obtenu par le fait qu'une couche épitaxiale en Ca(Si₁₋ₓGeₓ)₂, 0 < x ≤ 1, est déposée sur un substrat en germanium cristallin ou en germanium silicium.

8. Polymère en couche suivant l'une des revendications précédentes, dans lequel la couche épitaxiale en Ca(Si₁₋ₓGeₓ)₂, 0 < x ≤ 1, est produite par dépôt de Ca sur un substrat en Si₁₋ₓGeₓ, 0 < x ≤ 1, avec par la suite mise en température, par dépôt de Ca sur un substrat en Si₁₋ₓGeₓ chauffé, 0 < x ≤ 1, par codépôt de Ca, Ge et Si sur un substrat, de préférence un substrat en germanium ou en Si_{1- x}Geₓ, 0 < x ≤ 1, avec par la suite mise en température ou par codépôt de Ca, Ge et Si sur un substrat chauffé, de préférence un substrat en germanium ou en Si₁₋ₓGeₓ, 0 < x ≤ 1.

9. Polymère en couche suivant l'une des revendications précédentes, dans lequel des ligands H des polymères en couche sont d'abord remplacés par du Br par introduction du polymère en couche dans HBr et ensuite les ligands Br sont remplacés par des groupes OH dans l'eau.

10. Polymère en couche suivant l'une des revendications 1 à 8, dans lequel des ligands H des polymères en couche sont remplacés par des groupes alkyle par hydrosilylation de groupes alcényle.

11. Polymère en couche suivant l'une des revendications précédentes, dans lequel les polymères en couche sont dopés par intercalation d'atomes alcalins ou alcalinoterreux.

12. Polymère en couche suivant la revendication 11, dans lequel les polymères en couche sont dopés par intercalation d'atomes de Li, de K ou de Ca.

13. Polymère en couche suivant l'une des revendications précédentes, qui comporte un matériau qui est parmi un groupe formé par GaAs, AlGaAs, GaAlP, GaN et InGaAlN.

14. Procédé pour produire un polymère en couche, **caractérisé en ce que** le polymère en couche est obtenu au moyen d'une transformation topochimique de Ca(Si₁₋ₓGeₓ)₂, 0 < x ≤ 1.

15. Procédé suivant la revendication 14, **caractérisé en ce qu'**une couche épitaxiale en Ca(Si₁₋ₓGeₓ)₂, 0 < x ≤ 1, est utilisée sur un substrat en germanium cristallin ou en germanium silicium pour la production du polymère en couche.

16. Procédé suivant la revendication 14 ou 15, **caractérisé en ce que** la couche épitaxiale en Ca(Si₁₋ₓGeₓ)₂, 0 < x ≤ 1 est obtenue par dépôt de Ca sur un substrat en Si₁₋ₓGeₓ, 0 < x ≤ 1, avec par la suite mise en température, par dépôt de Ca sur un substrat en Si₁₋ₓGeₓ chauffé, par codépôt de Ca, Ge et Si sur un substrat, de préférence un substrat en germanium ou en Si₁₋ₓGeₓ, 0 < x ≤ 1, avec par la suite mise en température, ou par codépôt de Ca, Ge et Si sur un substrat chauffé, de préférence un substrat en germanium ou un substrat en Si₁₋ₓGeₓ , 0 < x ≤ 1.

17. Procédé suivant l'une des revendications 14 à 16, **caractérisé en ce que** la transformation topochimique est effectuée avec un liquide contenant du HCl ou de l'H₂O.

18. Procédé suivant l'une des revendications 14 à 17, **caractérisé en ce que** la transformation topochimique est effectuée dans de l'air ayant un taux d'humidité relatif compris entre 10 et 100 %.

19. Composant optoélectronique, **caractérisé en ce qu'**il comporte un polymère en couche suivant l'une des revendications 1 à 13.

20. Composant optoélectronique suivant la revendication 19, **caractérisé en ce que** le polymère en couche (10) est luminescent.

21. Composant optoélectronique suivant l'une des revendications 19 à 20, **caractérisé en ce que** la luminescence a un maximum d'intensité pour une longueur d'onde comprise entre 400 nm et 1600 nm.

22. Composant optoélectronique suivant l'une des revendications 19 à 21, **caractérisé en ce qu'**il comporte un substrat cristallin sur lequel est produit le polymère en couche.

23. Composant optoélectronique suivant la revendication 22, **caractérisé en ce que** le substrat (12) cristallin est un substrat en germanium ou un substrat en silicium germanium.

24. Composant optoélectronique suivant l'une des revendications 22 à 23, **caractérisé en ce que** le substrat (12) comporte une orientation telle que la structure du polymère en couche (10) n'est pas orientée parallèlement à la surface du substrat.

25. Composant optoélectronique suivant l'une des revendications 22 à 24, **caractérisé en ce que** le substrat (12) comporte une (110)-surface.

26. Composant optoélectronique suivant l'une des revendications 22 à 25, **caractérisé en ce qu'**il est utilisé un substrat (12) dopé.

27. Composant optoélectronique suivant l'une des revendications 22 à 26, **caractérisé en ce qu'**il est disposé sur le polymère en couche (10) un contact (16) électrique.

28. Composant optoélectronique suivant la revendication 27, **caractérisé en ce que** le contact (16) électrique est constitué d'un métal ou d'un oxyde conducteur de l'électricité.

29. Composant optoélectronique suivant l'une des revendications 27 à 28, **caractérisé en ce que** le contact (16) est transparent.

30. Composant optoélectronique suivant l'une des revendications 27 à 29, **caractérisé en ce que** le contact (16) contient du Sr, Ca, Mg, Al, Zn, In, ZnO, InO ou du InZnO.

31. Composant optoélectronique suivant l'une des revendications 19 à 30, **caractérisé en ce que** le polymère en couche (10) est dopé complètement ou sélectivement dans l'espace.

32. Composant optoélectronique suivant l'une des revendications 19 à 31, **caractérisé en ce qu'**il constitue une diode luminescente ou une diode laser.

33. Composant optoélectronique suivant l'une des revendications 19 à 31, **caractérisé en ce qu'**il sert à détecter un rayonnement optique.

34. Circuit intégré, **caractérisé en ce qu'**il comporte un polymère en couche suivant l'une des revendications 1 à 13 ou un composant optoélectronique suivant l'une des revendications 19 à 33.
